# FASCICULE DE BREVET EUROPEEN

(11) **EP 0 617 143 B1**
(45) Date de publication et mention de la délivrance du brevet: **02.06.1999**
(21) Numéro de dépôt: 94470005.3
(22) Date de dépôt: 16.03.1994
(51) Int. Cl.: C23C 16/54, C23C 16/02

(54) **Procédé et dispositif pour le revêtement en continu d'un matériau métallique**
Verfahren und Vorrichtung zum kontinuierlichen Beschichten eines metallischen Materials
Method and apparatus for continuous coating of metallic material

(30) Priorité: 26.03.1993 FR 9303709
(43) Date de publication de la demande: 28.09.1994
(73) Titulaire: SOLLAC S.A., 92800 Puteaux (FR)
(72) Inventeur: Schuster, Frédéric, F-78100 Saint Germain en Laye (FR); Piet, Gérard, F-95870 Bezons (FR)
(74) Mandataire: Ventavoli, Roger

(56) Documents cités:
- EP-A- 0 299 754
- WO-A-86/07391
- WO-A-93/06258
- PATENT ABSTRACTS OF JAPAN vol. 9, no. 199 (P-380) 16 Août 1985 & JP-A-60 063 724 (HITACHI MAXELL KK) 12 Avril 1985
- PATENT ABSTRACTS OF JAPAN vol. 15, no. 47 (P-1162) 5 Février 1991 & JP-A-02 281 420 (MATSUSHITA ELECTRIC IND CO LTD) 19 Novembre 1990

## Description

La présente invention concerne le revêtement des matériaux métalliques par des polymères organiques tels que des polysilanes ou polysiloxanes, notamment dans le but de protéger ces produits contre la corrosion.

Le revêtement des produits métallurgiques par des polymères au moyen de procédés utilisant un plasma froid crée dans une atmosphère sous pression réduite renfermant leurs monomères est à présent bien connu. Les dépôts obtenus peuvent avoir pour fonctions de protéger le substrat métallique contre la corrosion, ou de favoriser l'adhérence sur le produit d'une couche de peinture ou d'un autre polymère déposé par une autre technique. A cet effet, des polymères formés à partir de monomères oxygénés tels que des silanes ou des siloxanes sont utilisables. Ces polymères sont particulièrement intéressants en ce que, selon les conditions de température et de pression dans l'enceinte sous pression réduite où a lieu le traitement, et aussi selon les paramètres électriques qui régissent la formation du plasma, la dissociation des molécules de monomère dans le plasma est plus ou moins poussée. Dans le cas d'une forte dissociation, le polymère qui se dépose sur le substrat a un caractère "minéral" poussé, c'est-à-dire que les liaisons Si-O y sont particulièrement nombreuses. Dans le cas d'une faible dissociation, le polymère a, au contraire, un caractère "organique" très prédominant, avec des liaisons Si-O guère plus importantes que dans le monomère.

On peut désirer effectuer sur le produit à revêtir un dépôt de plusieurs couches de polymère superposées, chacune de ces couches étant de nature différente. Cela est assez facile lorsque le produit est une pièce unique maintenue fixe lors des étapes de revêtement : il suffit, lorsque le dépôt d'une couche est considéré comme achevé, de faire varier de manière appropriée les paramètres du traitement (composition de l'atmosphère, paramètres électriques...) pour réaliser le dépôt de la couche suivante. Il est en particulier connu de réaliser successivement un dépôt de polysilane ou de polysiloxane puis un dépôt de silice en introduisant dans l'enceinte de traitement d'abord un monomère de silane ou de siloxane pur pour former la couche de polymère, puis en le mélangeant à de l'oxygène pour former la couche de silice. En revanche, lorsque le produit est une bande en défilement qui doit être revêtue en continu, cela n'est possible, selon les procédés connus (voir par exemple la demande de brevet français FR 91 13720) qu'en faisant passer le produit successivement à travers plusieurs enceintes. A l'intérieur de chacune de ces enceintes sont établies des conditions adaptées au dépôt sur le produit d'une couche de nature déterminée, et ces enceintes doivent être séparées les unes des autres de manière étanche. Cela conduit à construire des installations relativement complexes. De plus, celles-ci ne permettent pas de réaliser un changement graduel de la composition du dépôt, puisque la limite entre les différentes couches est toujours définie de manière franche. Or un tel changement graduel peut être désiré afin d'obtenir une adhérence maximale d'une couche donnée sur la couche précédemment déposée. Ce problème se pose par exemple lorsqu'on veut déposer plusieurs couches d'un même polymère de base, lesdites couches ayant alternativement un caractère organique et minéral.

Le but de l'invention est de proposer un moyen pour réaliser à l'intérieur d'une même enceinte le dépôt de plusieurs couches successives, de caractère minéral ou organique dominant, d'un même polymère sur un produit métallique en défilement.

A cet effet, l'invention a pour objet un procédé de revêtement en continu par un dépôt de polymère d'un matériau métallique en défilement à l'intérieur d'une enceinte sous pression réduite selon lequel, à l'intérieur de ladite enceinte, on injecte à l'état gazeux le monomère dudit polymère et on crée les conditions de formation d'un plasma froid de manière à provoquer un revêtement dudit matériau par ledit dépôt de polymère, caractérisé en ce que, dans au moins une région de ladite enceinte, mais non dans sa totalité, on fait traverser audit matériau un champ magnétique, de manière à provoquer dans ladite région une variation de la composition dudit dépôt de polymère.

L'invention a également pour objet un dispositif pour le revêtement en continu par un dépôt de polymère d'un matériau métallique en défilement, du type comportant une enceinte étanche munie de moyens pour y obtenir et y maintenir une pression réduite, des moyens pour assurer le défilement dudit matériau à l'intérieur de ladite enceinte, des moyens pour introduire dans l'enceinte à l'état gazeux le monomère dudit polymère, des moyens pour créer à l'intérieur de ladite enceinte les conditions de formation d'un plasma froid sur le trajet dudit matériau en défilement, caractérisé en ce qu'il comprend également des moyens pour superposer audit plasma froid un champ magnétique sur une fraction dudit trajet dudit matériau en défilement.

L'invention a enfin pour objet un produit obtenu par le procédé selon l'invention.

Comme on l'aura compris, l'invention consiste à faire traverser au produit, lors de sa progression dans l'enceinte de traitement renfermant le monomère du polymère à déposer, plusieurs zones successives dans chacune desquelles il est mis en présence d'un plasma froid entraînant un dépôt de polymère sur sa surface. Dans l'une de ces zones au moins, on superpose à l'influence de ce plasma celle d'un champ magnétique. Celui-ci modifie sensiblement les conditions dans lesquelles réagissent les molécules de monomère, au point de changer la nature chimique du dépôt qui, dans la zone en question, se forme sur le produit. Par rapport aux procédés habituels de formation sur le substrat métallique de plusieurs couches de natures différentes à partir du même monomère, celle-ci ne nécessite pas de modifier l'atmosphère de l'enceinte, et les différents dépôts peuvent ainsi être effectués en continu dans la même enceinte.

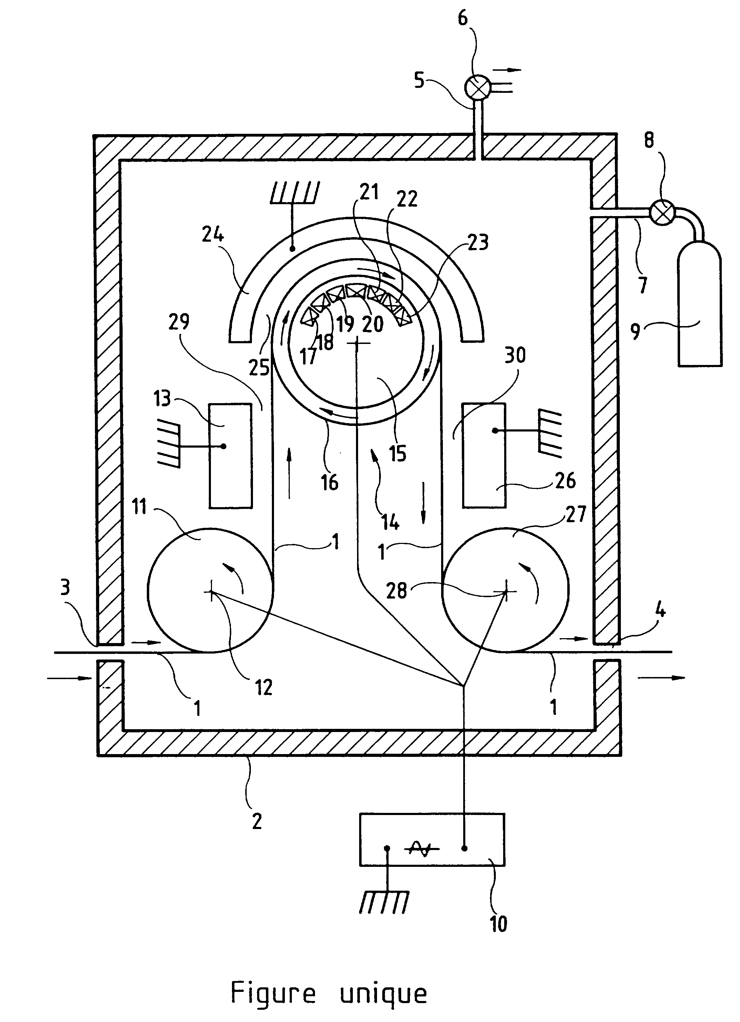

L'invention sera mieux comprise à la lecture de la description qui suit, faisant référence à la figure unique qui montre schématiquement un exemple de dispositif selon l'invention.

Sur cette figure unique, le produit à revêtir se présente sous la forme d'une bande 1 en un métal tel que de l'acier nu ou de l'acier galvanisé, mise en défilement par des moyens classiques (non représentés). On désire ici la revêtir sur une des ses faces par un polymère organique dont le monomère renferme des atomes de silicium et d'oxygène. Ce polymère est susceptible de présenter un caractère minéral plus ou moins marqué, c'est-à-dire d'avoir une proportion plus ou moins importante de liaisons Si-O par rapport aux liaisons Si-Si, Si-C, et Si-H. Un polysilane ou un polysiloxane répond à ces critères. A cet effet, on fait pénétrer la bande 1 dans une enceinte étanche 2. La pénétration de la bande 1 dans l'enceinte 2 s'effectue par un orifice d'entrée 3 et la bande 1 sort de l'enceinte 2 par un orifice de sortie 4. Ces deux orifices 3 et 4 sont munis de moyens d'étanchéité non représentés afin d'isoler l'enceinte 2 de l'extérieur même lorsque la bande 1 y est engagée. Annexée à l'enceinte 2, on trouve également une conduite 5 la reliant à l'extérieur par l'intermédiaire d'une pompe 6. Cette pompe 6 permet de maintenir dans l'enceinte 2 une pression réduite déterminée, de l'ordre de 0,1 à 1000 Pa, voire moins si nécessaire. Enfin, une autre conduite 7 est reliée par une vanne 8 à un réservoir 9 renfermant le monomère du polymère à déposer, ce monomère étant dans des conditions de température et de pression telles qu'il puisse s'échapper du réservoir 9 pour pénétrer à l'état de vapeur dans l'enceinte 2. L'installation comporte également un générateur de courant alternatif 10 dont l'un des pôles est relié à la terre et dont on verra loin à quels organes l'autre pôle est connecté.

Après sa pénétration dans l'enceinte 2, la bande 1 vient au contact d'un premier rouleau 11, en rotation libre ou assistée autour de son axe 12. Le rôle de ce premier rouleau 11 est double. Il assure d'abord le guidage de la bande 1 qu'il contribue à maintenir dans un état de tension et de planéité convenable. D'autre part, il est relié à l'un des pôles du générateur 10, et communique son potentiel à la bande 1. Après avoir quitté le premier rouleau 11, la bande 1 passe devant une première électrode 13 reliée à la masse définissant avec la bande 1 un espace 29. Puis la bande 1 vient au contact d'un deuxième rouleau 14. Ce deuxième rouleau, en matériau amagnétique, est construit en deux parties : un noyau fixe 15 et une virole extérieure 16 qui peut, grâce à des moyens appropriés non représentés tels que des roulements, tourner sur la surface du noyau fixe 15 lorsqu'elle est entraînée par la bande 1 avec laquelle elle est en contact. Ce deuxième rouleau 14 est relié au même pôle du générateur 10 que le premier rouleau 11, et contribue aussi à l'imposition à la bande 1 du potentiel du générateur 10. Dans le noyau fixe 15 sont intégrés des aimants permanents 17,18,19,20,21,22,23 répartis selon la circonférence du noyau fixe 15 au voisinage de sa surface, en regard de la zone de la circonférence de la virole 16 qui est en contact avec la bande 1. Face à une partie au moins de cette zone et en regard des aimants permanents 17 à 23 est disposée une deuxième électrode 24, reliée à la masse, et qui définit avec la bande 1 un espace 25 de largeur sensiblement constante (quoique cela ne soit pas à proprement parler obligatoire). Après avoir quitté le deuxième rouleau 14, la bande 1 défile devant une troisième électrode 26 identique à la première électrode 13, et elle aussi reliée à la masse. La bande 1 et la troisième électrode 26 définissent un espace 30. Puis elle passe sur un troisième rouleau 27 en rotation libre ou assistée autour de son axe 28 et relié au même pôle du générateur 10 que les deux autres rouleaux 11, 14. Son rôle est comparable à celui du premier rouleau 11. Puis la bande 1 sort de l'enceinte 2 par l'orifice 4.

L'installation est utilisée comme suit. On introduit d'abord le début de la bande 1 dans l'enceinte 2. Puis on met l'enceinte sous pression réduite, et on y introduit le monomère du polymère à déposer, par exemple l'hexaméthyldisiloxane (HMDS) de manière à maintenir une pression partielle de HMDS de l'ordre de 10 à 100 Pa par exemple. Puis, on fait débuter le défilement de la bande 1 et on met en marche le générateur 10 à une fréquence de l'ordre de 50 kHz avec une puissance de quelques dizaines de W. On obtient ainsi une polarisation de la bande 1 qui se comporte en cathode, alors que les trois électrodes 13, 24, 26 se comportent en anodes. Sous l'effet de la différence de potentiel régnant entre la bande 1 et les électrodes 13, 24, 26, on assiste à la création, à l'intérieur des espaces 25, 29, 30 qui les séparent, d'un plasma basse température. Celui-ci a pour effet de dissocier les molécules de HMDS, et celles-ci se déposent sous forme d'un polymère de type polysiloxane sur la face de la bande 1 qui défile devant les électrodes.

Comme on l'a dit, ce polysiloxane peut présenter un caractère minéral plus ou moins marqué. Or, la présence dans le noyau fixe du deuxième rouleau 14 des aimants permanents 17 à 23 modifie très sensiblement les conditions opératoires dans l'espace 25, par rapport à celles régnant dans les espaces 29 et 30. On y obtient, en effet, des conditions de type "pulvérisation magnétron", qui sont connues pour provoquer une dissociation très poussée des molécules de monomère, et des vitesses de dépôt du polymère particulièrement élevées. Et ces conditions vont de pair avec un caractère minéral accentué pour ledit dépôt de polymère. Il est donc possible, en utilisant l'installation qui vient d'être décrite de réaliser successivement le dépôt de trois couches alternées de polymère sur la bande 1 :
- une première couche, à dominante organique, déposée face à la première électrode 13 ;
- une deuxième couche, à caractère minéral plus marqué, déposée face à la deuxième électrode 24, alors que le champ magnétique créé par les aimants permanents 17 à 23 se superpose au champ électrique régnant entre la bande 1 et l'électrode 24 ;
- une troisième couche, à dominante organique, déposée face à la troisième électrode 26.

A titre d'exemple, les conditions opératoires suivantes peuvent être utilisées :
- générateur 10 d'une puissance de 80 W et de fréquence 50 kHz ;
- pression de HMDS dans l'enceinte 1 : 0,3 mbar ;
- champ magnétique entre la deuxième électrode 24 et le deuxième rouleau 14 : intensité de l'ordre de 1000 G.

Dans ces conditions, face aux deux électrodes 13 et 26 non affectées par un champ magnétique, on observe une vitesse de croissance de la couche de polymère d'environ 0,3 µm/min. En revanche, face à la deuxième électrode 24, sous l'influence du champ magnétique, on observe une vitesse de croissance de la couche de polymère d'environ 2,4 µm/min. D'autre part, comme on l'a dit, cette couche présente un caractère minéral plus fort que les deux autres.

En fonction du temps que passe la bande 1 dans les diverses parties de l'installation (donc en fonction de la vitesse de défilement de la bande 1 et de la longueur des électrodes 13,24,26), il est possible de réaliser des couches de polymère d'épaisseur respectives plus ou moins importantes. Les vitesses de dépôt particulièrement élevées constatées notamment pour la zone soumise au champ magnétique rendent ce procédé compatible avec une marche industrielle où la bande 1 défilerait à une vitesse de 25 à 50 m/min dans un réacteur qui n'aurait que 2 à 4 m de longueur. On pourrait ainsi obtenir des dépôts d'épaisseur de 2000 à 2500 Å dont on sait qu'ils constituent de bonnes barrières contre la corrosion sur des produits en acier revêtus d'alliage zinc-nickel et d'autres produits galvanisés.

Dans l'exemple décrit, on obtiendrait donc une première couche de polysiloxane à dominante organique, une deuxième couche de polysiloxane à dominante minérale, et une troisième couche de polysiloxane à dominante organique. L'intérêt d'un tel produit multicouche par rapport à un produit qui ne présenterait qu'une seule couche de polysiloxane à caractère minéral ou organique est qu'un tel dépôt multicouche constitue une meilleure barrière contre la corrosion qu'un dépôt monocouche d'épaisseur équivalente. D'autre part, on peut ainsi profiter à la fois des propriétés avantageuses des deux types de revêtement : par exemple de la meilleure résistance mécanique des dépôts à fort caractère minéral par rapport aux dépôts à dominante organique, et du caractère plus hydrophobe de ces derniers qui les rendent plus aptes à recevoir une couche de peinture.

Bien entendu, on peut imaginer de multiples variantes à l'installation qui vient d'être décrite. On peut, par exemple, n'utiliser qu'un seul aimant permanent de grandes dimensions, ou tout autre dispositif d'imposition d'un champ magnétique. On peut aussi imposer des variations progressives du champ magnétique à l'intérieur de l'espace 25, champ qui, par exemple, irait croissant de l'aimant 17 à l'aimant 20, puis décroîtrait à nouveau jusqu'à l'aimant 23. On obtiendrait ainsi une variation progressive du caractère organique/minéral du dépôt de polymère qui garantirait une excellente cohésion du dépôt. De même on peut ne prévoir qu'une seule zone à dépôt non assisté par champ magnétique, et donc un dépôt de seulement deux couches différenciées de polymère ; ou inversement multiplier le nombre d'électrodes pour se donner la possibilité de multiplier d'autant le nombre de couches, voire de revêtir les deux faces de la bande en les faisant défiler successivement devant autant d'électrodes que nécessaire. Enfin, au lieu d'employer un générateur à courant alternatif classique, on peut employer un générateur de radiofréquences fonctionnant à 13,56 MHz, comme on en utilise couramment dans le domaine des traitements plasma. On pourrait aussi employer un générateur de courant continu. Toutefois, dans ce dernier cas, on serait contraint de limiter l'épaisseur de polymère déposée à quelques milliers d'Å seulement, car au-delà le caractère isolant du dépôt conduirait à des phénomènes de claquage qui endommageraient le revêtement. D'autre part, on peut prévoir des alimentations électriques séparées pour chaque électrode.

De même, tout autre dispositif que le rouleau 14 tel qu'il a été décrit peut être utilisé s'il assure des fonctions comparables aux siennes, à savoir la formation d'un plasma froid superposé à un champ magnétique sur une fraction du parcours de la bande 1 dans l'enceinte 2.

Enfin, les applications de l'invention ne se limitent pas au dépôt de polysilanes ou polysiloxanes, mais au dépôt de tout polymère dont la composition est influencée par la superposition d'un champ magnétique au plasma froid qui provoque la polymérisation.

## Revendications

1. Procédé de revêtement en continu par un dépôt de polymère d'un matériau métallique en défilement à l'intérieur d'une enceinte sous pression réduite, selon lequel, à l'intérieur de ladite enceinte, on injecte à l'état gazeux le monomère dudit polymère et on crée les conditions de formation d'un plasma froid de manière à provoquer un revêtement dudit matériau par ledit dépôt de polymère, caractérisé en ce que, dans une ou plusieurs des régions de ladite enceinte où on provoque le revêtement dudit matériau, mais non dans leur totalité, on fait traverser audit matériau un champ magnétique, de manière à provoquer dans la ou lesdites régions une variation de la composition dudit dépôt de polymère.

2. Procédé selon la revendication 2, caractérisé en ce que ledit champ magnétique a une intensité variable le long de ladite région.

3. Dispositif pour le revêtement en continu par un dépôt de polymère d'un matériau métallique (1) en défilement, du type comportant une enceinte étanche (2) munie de moyens (5,6) pour y obtenir et y maintenir une pression réduite, des moyens pour assurer le défilement dudit matériau (1) à l'intérieur de ladite enceinte (2), des moyens (7,8,9) pour introduire dans l'enceinte (2) à l'état gazeux le monomère dudit polymère, des moyens (11,13,24,26,27) pour créer à l'intérieur de ladite enceinte (2) les conditions de formation d'un plasma froid sur le trajet dudit matériau (1) en défilement, caractérisé en ce qu'il comprend également des moyens (17,18,19,20,21,22,23) pour superposer audit plasma froid un champ magnétique, lesdits moyens étant disposés sur une ou plusieurs des portions dudit trajet dudit matériau (1) en défilement où le plasma froid est formé, mais non sur la totalité dudit trajet.

4. Dispositif selon la revendication 3, caractérisé en ce que lesdits moyens (17,18,19,20,21,22,23) pour superposer un champ magnétique audit plasma froid sur une fraction dudit trajet dudit matériau (1) en défilement sont inclus dans un rouleau amagnétique (14) comprenant un noyau fixe (15) dans lequel sont placés lesdits moyens (17,18,19,20,21,22,23), et une virole (16) pouvant tourner sur la surface dudit noyau fixe, la surface externe de ladite virole (16) étant conçue pour supporter ledit matériau (1) en défilement.

5. Dispositif selon la revendication 3 ou 4, caractérisé en ce que lesdits moyens ((17,18,19,20,21,22,23) pour superposer audit plasma froid un champ magnétique sont constitués par au moins un aimant permanent.

6. Produit métallique ayant été revêtu en continu par un dépôt de polymère au moyen d'un procédé utilisant un plasma froid, ledit dépôt étant formé de plusieurs couches de compositions différentes, caractérisé en ce que lesdites couches ont été obtenues à partir du même monomère, l'une des couches au moins ayant été formée en présence d'un champ magnétique superposé audit plasma froid, et présentant une variation progressive de son caractère organique/minéral.

7. Produit métallique selon la revendication 6, caractérisé en ce que ledit polymère a pour monomère un polysilane ou un polysiloxane.

## Patentansprüche

1. Verfahren zum kontinuierlichen Beschichten eines durch das Innere einer Kammer mit verringertem Druck laufenden metallischen Materials mit einer Polymerablagerung, wobei das Monomer dieses Polymers im gasförmigen Zustand in die Kammer eingeblasen wird und Bedingungen zur Erzeugung eines kalten Plasmas hergestellt werden, derart, daß eine Beschichtung des Materials durch Ablagerung von Polymer bewirkt wird, dadurch gekennzeichnet, daß in einem oder mehreren Bereichen der Kammer, in denen die Beschichtung des Materials bewirkt wird, nicht jedoch in ihrer Gesamtheit, das Material ein Magnetfeld durchläuft, sodass in dem oder den Bereichen eine Veränderung der Zusammensetzung der Polymerablagerung bewirkt wird.

2. Verfahren nach Anspruch 1, dadurch gekennzeichnet, daß das Magnetfeld eine variable Intensität entlang dieses Bereiches aufweist.

3. Vorrichtung zur kontinuierlichen Beschichtung eines sich bewegenden metallischen Materials (1) mit einer Polymerablagerung, mit einer dichten Kammer (2), die eine Anordnung (5, 6) aufweist, um in ihr einen verringerten Druck zu erzeugen und aufrechtzuerhalten, mit einer Anordnung, die den Durchlauf des Materials (1) im Inneren der Kammer (2) gewährleistet, mit einer Anordnung (7, 8, 9), um in die Kammer (2) ein Monomer des Polymers im gasförmigen Zustand einzuführen, mit einer Anordnung (11, 13, 24, 26, 27), um im Inneren der Kammer (2) Bedingungen für die Ausbildung eines kalten Plasmas auf den Weg des sich bewegenden Materials (1) herzustellen, dadurch gekennzeichnet, daß sie außerdem eine Anordnung (17, 18, 19, 20, 21, 22, 23) aufweist, um dem kalten Plasma ein Magnetfeld zu überlagern, wobei diese Anordnung in einem oder mehreren Abschnitten des Weges des durchlaufenden Materials (1) vorgesehen ist, in dem das kalte Plasma ausgebildet ist, nicht jedoch auf der Gesamtheit des Weges.

4. Vorrichtung nach Anspruch 3, dadurch gekennzeichnet, daß die Anordnung (17, 18, 19, 20, 21, 22, 23), die dem kalten Plasma ein Magnetfeld auf einem Teil des Weges des durchlaufenden Materials (1) überlagert, in einer nichtmagnetischen Walze (14) eingeschlossen ist, die einen feststehenden Kern (15) aufweist, in dem die Anordnung (17, 18, 19, 20, 21, 22, 23) eingesetzt ist und die einen Mantel (16) aufweist, der auf der Oberfläche des feststehenden Kerns drehbar angeordnet ist und auf dem sich das durchlaufende Material (1) abstützt.

5. Vorrichtung nach Anspruch 3 oder 4, dadurch gekennzeichnet, daß die Anordnung (17, 18, 19, 20, 21, 22, 23) die dem kalten Plasma ein Magnetfeld überlagert, aus wenigstens einem Permanentmagneten besteht.

6. Metallischer Gegenstand, der kontinuierlich mit einer Polymerablagerung beschichtet ist, mittels eines Verfahrens, welches ein kaltes Plasma verwendet, wobei die Ablagerung aus mehreren Schichten unterschiedlicher Zusammensetzungen besteht, dadurch gekennzeichnet, daß die Schichten ausgehend von einund demselben Monomer erhalten worden sind, daß wenigstens eine der Schichten in Gegenwart eines dem kalten Plasma überlagerten Magnetfeldes erhalten worden ist und daß sie eine zunehmende Variation der mineralischen/organischen Eigenschaft aufweist.

7. Metallischer Gegenstand nach Anspruch 6, dadurch gekennzeichnet, daß das Monomer für das Polymer ein Polysilan oder ein Polisiloxan ist.

## Claims

1. Process for continuously coating a running metallic material with a polymer coating inside a vacuum chamber, in which process the monomer of the said polymer is injected in the gaseous state into the said chamber and the conditions for generating a cold plasma so as to coat the said material with the said polymer coating are created, characterised in that, in one or more regions of the said chamber where the said material is coated, but not throughout them, the said material is made to pass through a magnetic field so as to cause a variation in the composition of the said polymer coating in the said region or regions.

2. Process according to Claim 1, characterised in that the said magnetic field has an intensity which varies along the said region.

3. Device for continuously coating a running metallic material (1) with a polymer coating, of the type comprising a sealed chamber (2) provided with means (5, 6) for both obtaining and maintaining a reduced pressure therein, means for making the said material (1) run inside the said chamber (2), means (7, 8, 9) for introducing into the chamber (2), in the gaseous state, the monomer of the said polymer and means (11, 13, 24, 26, 27) for creating, inside the said chamber (2), the conditions for generating a cold plasma in the path of the said running material (1), characterised in that it also comprises means (17, 18, 19, 20, 21, 22, 23) for superposing a magnetic field on the said cold plasma, the said means being arranged over one or more portions of the said path of the said running material (1) in which the cold plasma is generated, but not throughout the said path.

4. Device according to Claim 3, characterised in that the said means (17, 18, 19, 20, 21, 22, 23) for superposing a magnetic field on the said cold plasma over a fraction of the said path of the said running material (1) are included in a non-magnetic roll (14) comprising a fixed core (15), in which the said means (17, 18, 19, 20, 21, 22, 23) are placed, and a shell (16) which can rotate on the surface of the said fixed core, the external surface of the said shell (16) being designed to support the said running material (1).

5. Device according to Claim 3 or 4, characterised in that the said means (17, 18, 19, 20, 21, 22, 23) for superposing a magnetic field on the said cold plasma consists of at least one permanent magnet.

6. Metal product which has been continuously coated with a polymer coating by means of a process using a cold plasma, the said coating being formed from several layers of different compositions, characterised in that the said layers have been obtained from the same monomer, at least one of the layers having been formed in the presence of a magnetic field superposed on the said cold plasma and exhibiting a gradual variation in its organic/inorganic character.

7. Metal product according to Claim 6, characterised in that the monomer for the said polymer is a silane or a siloxane.
